# EUROPEAN PATENT APPLICATION

(11) **EP 2 533 318 A1**
(43) Date of publication of application: **12.12.2012**
(21) Application number: 11169108.5
(22) Date of filing: 08.06.2011
(51) Int. Cl.: H01L 51/42

(54) **Thin film solar cell module and greenhouse provided with the same**

(71) Applicant: Nederlandse Organisatie voor Toegepast -Natuurwetenschappelijk Onderzoek TNO, 2628 VK Delft (NL)
(72) Inventor: Blom, Paulus Wilhelmus Maria, 2628 VK Delft (NL); Galagan, Yulia, 2628 VK Delft (NL)
(74) Representative: Jansen, Cornelis Marinus

(57) **Abstract**

A thin film solar cell module (1) is disclosed that is substantially translucent in at least a first wavelength domain. The module comprises a photo-electric layer (20) arranged for receiving solar radiation and for converting solar radiation in at least a second wavelength domain different from the at least a first wavelength domain into electric energy and a selectively reflective layer (30) arranged against the photo-electric layer for selectively reflecting radiation in said second wavelength domain transmitted by the photo-electric layer. The module further comprises a further photo-electric layer (40) for absorbing and converting radiation in at least the second wavelength domain into electric energy, the selectively reflective layer (30) being arranged between the photo-electric layer (20) and the further photo-electric layer (40).

## Description

### BACKGROUND OF THE INVENTION

### Field of the invention

The present invention relates to a thin film solar cell module.

The present invention further relates to a greenhouse provided with a thin film solar cell module.

### Related Art

Greenhouses are important for the growth of plants such as vegetables and flowers. At day time plants in the greenhouses are lit by sunlight, whereas at night (dark) time artificial light is used. An important issue is that at night time greenhouses use a high amount of energy for the illumination of the plants. On the other hand, at day time plants only absorb a certain part of the solar spectrum, and the rest of the solar spectrum is not used.

EP2230695 discloses a photovoltaic greenhouse that comprises a main greenhouse frame structure comprising a plurality of upstanding walls and a roof supported by said upstanding walls; and at least one thin-film solar cell module mounted on said roof for converting solar energy into electricity by selectively absorbing a pre-selected light band of sunlight in a photo-electric layer, wherein said solar energy which is selectively transmitted by said at least one thin-film solar cell module comprises a light band of sunlight to facilitate photosynthesis by a given plant.

Also known are photo-electric modules that have in addition to a selectively absorbing photo-electric layer a selectively reflecting layer, with a reflection band in substantially the same range as the absorption band of the selectively absorbing photo-electric layer. In this way the efficiency of the photo-electric module is increased. Examples thereof are described by Y. Galagan, M.G. Debije, and P. Blom in "Semitransparent organic solar cells with organic wavelength dependent Reflectors" in APPLIED PHYSICS LETTERS 98, 043302_2011.

Greenhouses often are provided with additional light sources to illuminate the plants in the interior at night time. A substantial amount of radiation originating from these light sources escapes as stray radiation and leads to the problem of "light pollution". "Light pollution" is defined as excessive or obtrusive light at night. The problem of "light pollution" from greenhouses is very relevant in densely populated areas. This excessive light in the environment can have negative effects to the health of people living close to a greenhouse (i.e. lack of sleep). It is desirable to reduce this light pollution and additionally to convert at least part of the stray radiation into electric energy. The thin-film solar cell module known from EP2230695 would be capable of converting stray radiation. However, it would not be possible to use a photo-electric module having in addition to the selectively absorbing photo-electric layer a selectively reflecting layer. This reflecting layer would reflect the stray radiation in the wavelength band suitable for the photo-electric layer, before it reaches the photo-electric layer. It is desired to provide a photo-electric module that is capable of both converting solar radiation received from outside the greenhouse as well as converting stray radiation from illumination sources inside the greenhouse and that still has an increased conversion efficiency.

### SUMMARY OF THE INVENTION

According to a first aspect of the invention an improved thin-film solar cell module is provided that is substantially translucent in at least a first wavelength domain, wherein a photo-electric layer is arranged for receiving solar radiation and for converting solar radiation in at least a second wavelength domain different from the at least a first wavelength domain into electric energy. The thin-film solar cell module has a selectively reflective layer arranged against the photo-electric layer for reflecting radiation in said second wavelength domain transmitted by the photo-electric layer. The module comprises a further photo-electric layer for absorbing and converting radiation in at least the second wavelength domain into electric energy. The selectively reflective layer is arranged between the photo-electric layer (in the sequel also denoted as first photo-electric layer) and the further photo-electric layer (in the sequel also denoted as second photo-electric layer).

The thin-film solar cell module according to the first aspect of the invention is particularly suitable for application with a greenhouse wherein auxiliary illumination is applied, for example in the absence of solar radiation. Stray radiation from the auxiliary radiation source inside the second wavelength domain is absorbed by the second photo-electric layer and converted into electric energy. The selectively reflective layer arranged between the first and the second photo-electric layer improves the efficiency of both photo-electric layers.

Solar radiation within the second wavelength domain that is not directly absorbed by the first photo-electric layer is reflected by the selectively reflective layer and is then at least partly absorbed and converted into electric energy.

Considering that the first photo-electric layer absorbs and converts a portion Cpa of the photon radiation and that the selectively reflective layer has a reflectivity of Crr in the at least a second wavelength domain, then a portion (1-Cpa)*Crr is reflected back to the first photo-electric layer and an additional portion Cpa*(1-Cpa)*Crr is absorbed in the first photo-electric layer for conversion into electric energy. Accordingly the absorption of the thin-film solar cell module in the second wavelength domain is improved by a factor 1+(1-Cpa)*Crr. Presuming that the transmission of the selectively reflective layer in the first wavelength domain is Crt, this implies that the selectivity of the thin-film solar cell module is improved by (1+(1-Cpa)*Crr)*Crt.

Likewise, stray radiation within the second wavelength domain that is not directly absorbed by the second photo-electric layer is reflected by the selectively reflective layer and is then at least partly absorbed and converted into electric energy.

In practice selectively reflective layers can be designed that closely approach a desired high reflection spectrum with only modest absorption losses. For example a selectively reflective layer may have a transmission for the first wavelength domain of 90% and a reflection for the second wavelength domain of 90%. In that case the selectivity of a thin-film solar cell module having a photo-electric layer that absorbs and converts a portion Cpa = 0.5 of the photon radiation is improved by a factor 1.4.

By selectively reflecting radiation in said second wavelength domain part of that radiation, which would otherwise be lost is now absorbed in the photo-electric layer, while the radiation in the at least a first wavelength domain is transmitted unhindered to the interior of the greenhouse. The additionally absorbed radiation is converted into electrical energy, therewith improving conversion energy, while maintaining a good transmission of the sunlight in the wavelength bands relevant for photosynthesis.

In an embodiment the at least a first wavelength domain comprises a first wavelength range from 350 nm to 500 nm and a second wavelength range from 600 nm to 700 nm. Accordingly the thin-film solar cell module should transmit at least 50% of the radiation in these wavelength ranges. Preferably the transmission therein should be at least 75%. Even more preferably the transmission therein should be at least 90%.

In said embodiment the second wavelength domain extends from 500 to 600 nm. The selectively reflective layer should have a reflectivity of at least 50% of the radiation in the second wavelength domain. Preferably the reflectivity therein should be at least 75%. Even more preferably the reflectivity therein should be at least 90%.

The article of Y. Galagan et al. cited herein describes solution-processable organic wavelength dependent reflectors of chiral nematic cholesteric liquid crystals for use in semitransparent organic solar cells. The cholesteric liquid crystal (CLC) reflects only in a narrow band of the solar spectrum and remains transparent for the remaining wavelengths. The reflective band is matched to the absorption spectrum of the organic solar cell such that only unabsorbed photons suitable for photo-electric conversion are reflected to pass through the active layer a second time. In this way, the efficiency of semitransparent organic solar cells can be enhanced without significant transparency losses. Reference is further made to S.H. Chen, Photoracemization broadening of selective reflection and polarization band of glassy chiral-nematic films, Liquid Crystals, 2000, Vol. 27, No. 2, 201-209.

Other known methods are described for example in USP7515336B2, USP6847483, and USP6197224. Also software for designing selectively reflective layer comprising a plurality of sub-layers is commercially available, for example the software package TFCalc from Software Spectra Inc, http://www.sspectra.com/.

According to a second aspect of the invention a greenhouse provided with an improved thin-film solar cell module is provided. The photovoltaic greenhouse according to the second aspect comprises a main greenhouse frame structure comprising a wall enclosing an inner space for growing plants, at least one thin-film solar cell module as claimed in one of the previous claims, mounted on said wall. The wall may have wall-segments, for example the wall may have upstanding segments and a roof segment. Alternatively, the wall may be formed as a single part, for example as a hemi-spherical part.

### BRIEF DESCRIPTION OF THE DRAWINGS

These and other aspects are described in more detail with reference to the drawing. Therein:
FIG. 1 shows the absorption spectra of chlorophyll a and b,
FIG. 2 shows a conventional thin film solar cell module,
FIG. 3 shows a greenhouse provided with a conventional thin film solar cell module, during day time,
FIG. 3A shows the greenhouse of FIG. 3 during night time,
FIG. 4 shows an embodiment of a thin film solar cell module according to the first aspect of the invention,
FIG. 5 shows an embodiment of a greenhouse according to the second aspect of the invention, during night time,
FIG. 6 shows an aspect of a thin film solar cell module according to the first aspect of the invention in more detail.

### DETAILED DESCRIPTION OF EMBODIMENTS

Like reference symbols in the various drawings indicate like elements unless otherwise indicated.

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the size and relative sizes of layers and regions may be exaggerated for clarity. Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing. Thus, the regions illustrated in the figures are schematic in nature and their shapes are not intended to illustrate the actual shape of a region of a device and are not intended to limit the scope of the invention.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein. In case of conflict, the present specification, including definitions, will control. In addition, the materials, methods, and examples are illustrative only and not intended to be limiting.

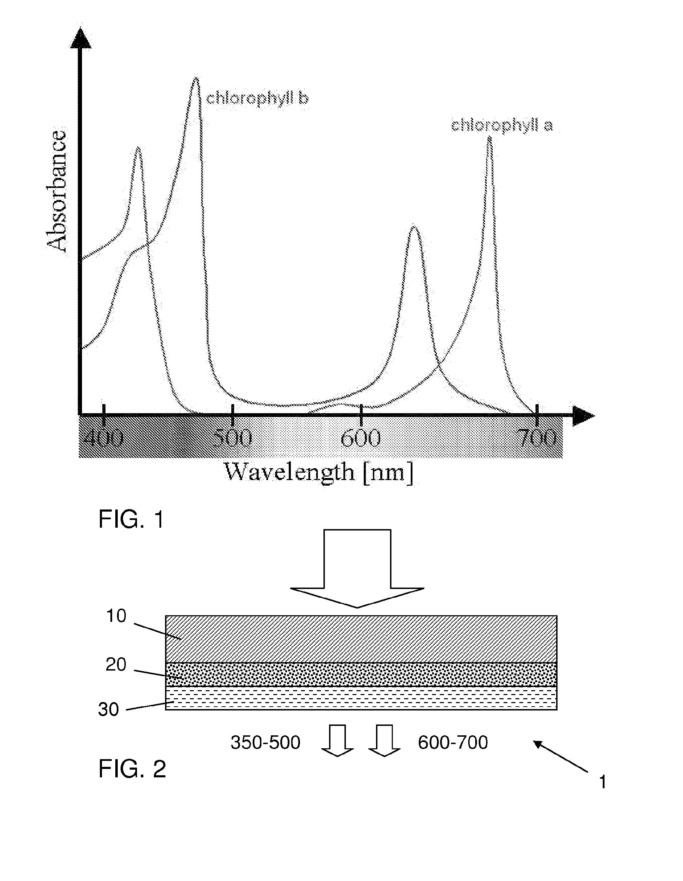

Sunlight is a full-spectrum light. Plants however use only part of the spectrum for photosynthesis. This is illustrated in FIG. 1 which shows the absorption spectra of chlorophyll a and b, the pigments that are responsible for the photosynthesis in the plants. A large spectral region, typically between 500-600 nm, is not suitable for photosynthesis.

FIG. 2 schematically shows a thin film solar cell module as known from the cited publication of Galagan et al.. The thin film solar cell module comprises a substrate 10, carrying a photo-electric layer 20 and a selectively reflective layer 30.

The photo-electric layer 20 is arranged between the substrate 10 and the selectively reflective layer 30. The substrate may be of glass or a translucent polymer, such as a PET or PEN foil. The photo-electric layer 20 is formed by sub-layers of Poly_3-hexylthiophene (P3HT) and [C60] PCBM. As a selectively reflective layer 30 a stack of cholesteric liquid crystal (CLC) sub-layers is used that each reflects only in a narrow band of about 80 nm and remains transparent for the remaining wavelengths. A stack of such CLC-sub-layers each having its reflection band in a respective wavelength forms the selectively reflective layer 30 having an aggregate reflection band that matches the absorption band of the photo-electric layer 20. The reflective band is matched to the absorption spectrum of the organic solar cell such that mainly unabsorbed radiation in the second wavelength domain is reflected to the photo-electric layer 20. Dependent on the application used, also other materials may be used for the photo-electric layer. For example the active material P3HT may be replaced by a more ordered organic material to achieve a more narrow absorption band for the photo-electric layer.

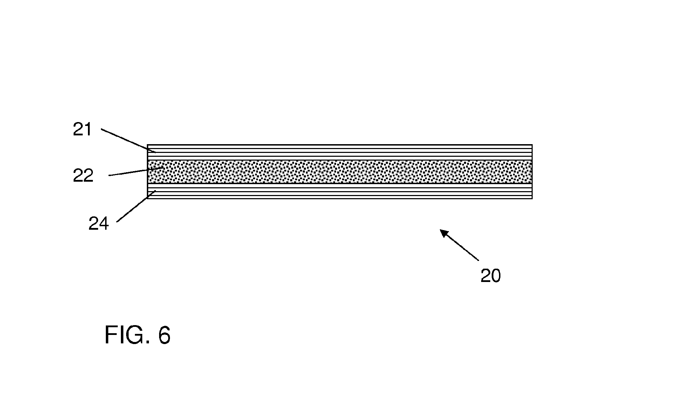

Further examples of the photo-electric layer 20 are described in more detail with reference to FIG. 6.

The thin film solar cell module is substantially translucent in a first wavelength domain comprising the wavelength band 350 to 500 nm and the wavelength band of 600 to 700 nm. In particular the film solar cell module should transmit at least 75% of the radiation in the wavelength bands from 420 to 480 nm, and from 620 to 700 nm. The thin-film solar cell module should block at least 75% of the radiation in the wavelength range of 500 to 600 nm. The percentages indicated are a percentage of the power of the photon radiation. The photo-electric layer is arranged for receiving solar radiation and for converting solar radiation in at least a second wavelength domain of 500 to 600 nm, different from the at least a first wavelength domain into electric energy. The selectively reflective layer 30 is arranged against the photo-electric layer and selectively reflects radiation in the second wavelength domain transmitted by the photo-electric layer. The selectively reflective layer comprises for example a stack of sub-layers having an alternating refractive index, such as TiO2 and ZrO2 layers. Alternatively or in addition thin film materials such as a Polymer Dispersed Liquid Crystals film or a Dual Brightness Enhancement Film (DBEF, Vikuiti™) from 3M may be used.

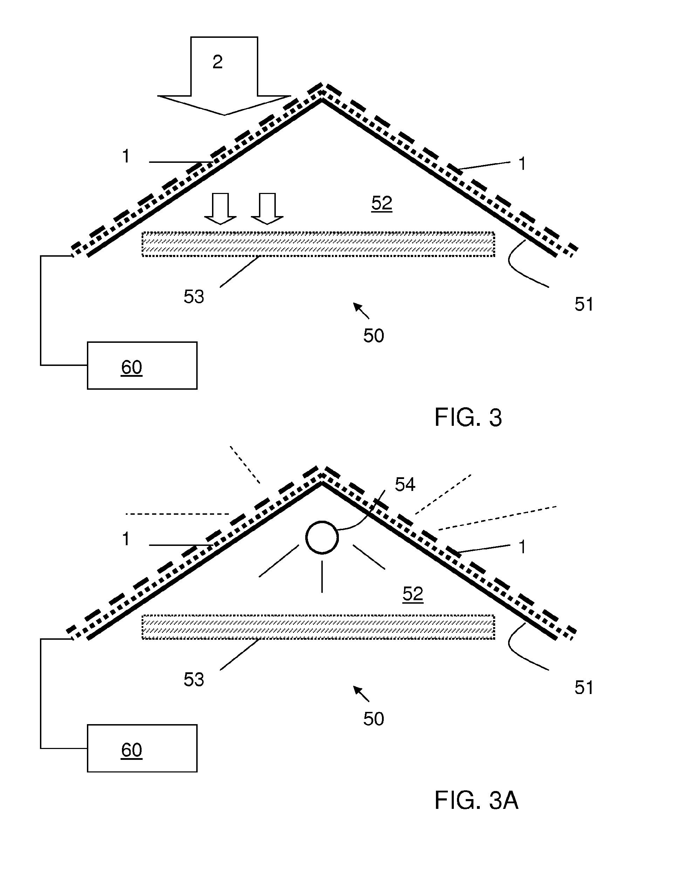

FIG. 3 schematically shows a greenhouse provided with a thin film solar cell module as shown in FIG. 2. The greenhouse shown in FIG. 3 comprises a main greenhouse frame structure comprising a wall 51 enclosing an inner space 52 for growing plants 53. A thin-film solar cell module 1 as described with reference to FIG. 2 is mounted on the wall. The selectively reflecting layer 30 is arranged between the photo-electric layer 20 and the wall.

During day time solar radiation 2 is received by the photo-electric layer 20 of the thin film solar cell module 1. The solar radiation in the wavelength band of 350 to 500 nm and the wavelength band of 600 to 700 nm is substantially transmitted, therewith causing photosynthesis in the plants 53 arranged in the interior 52 of the greenhouse 50. The solar radiation in the wavelength domain of 500 to 600 nm is partly absorbed by the photo-electric layer 20 and converted into electric energy that is delivered to an electric system 60. The electric system 60 for example comprises a DC/AC converter for converting the electric energy in a form suitable for supplying to the mains. Alternatively the electric system 60 may comprise a storage facility.

FIG. 3A shows the situation during night time. During night time the plants 53 in the greenhouse may be artificially illuminated by a light source 54. This light source may be powered by energy retrieved at day time from the thin film solar cell module 1. In this case stray radiation from the light-source 54 is substantially weakened as radiation in the second wavelength domain is reflected by the layer 30. However, substantially no radiation in the second wavelength domain reaches the photo-electric layer 20 therewith preventing a conversion thereof into electric energy.

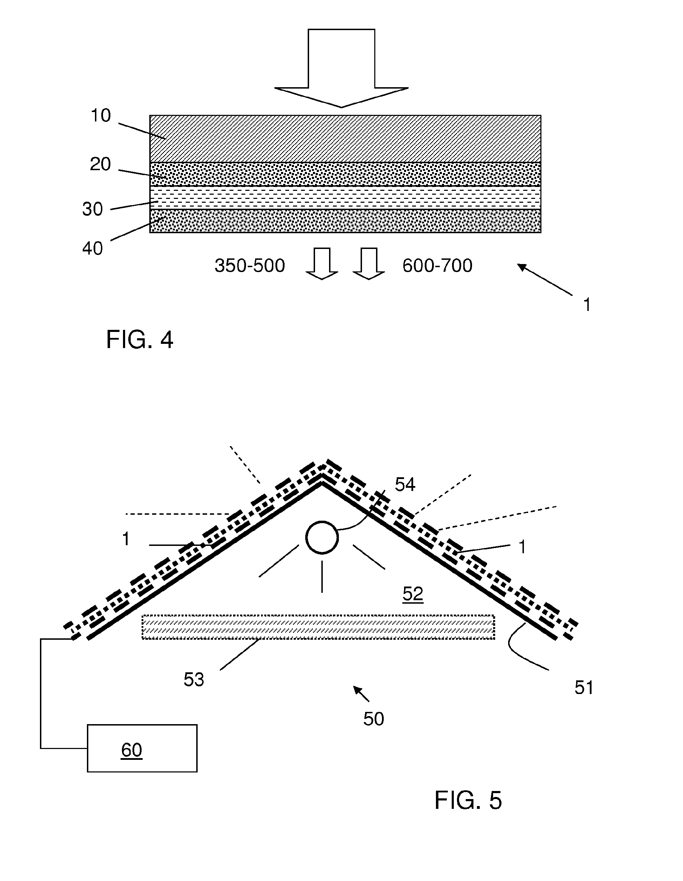

FIG. 4 shows an embodiment of a thin film solar cell module 1 according to the first aspect of the invention. The thin film solar cell module shown in FIG. 4, comprises an additional photo-electric layer 40 that is arranged at the opposite side of the selectively reflective layer 30. Accordingly the selectively reflective layer 30 is arranged between the first photo-electric layer 20 and the second photo-electric layer 40. The first photo-electric layer 20 and the second photo-electric layer 40 of the module of FIG. 4 may have the same composition and dimensions as those of FIG. 2. The selectively reflective layer 30 may also have the same composition and dimensions as that of FIG. 2. However, alternatively a stack of sub-layers of alternating refractive index, e.g. a stack of TiO2 and ZrO2 layers maybe used.

It is not relevant at which side of the thin-film solar cell module 1 the substrate 10 is arranged. In an embodiment a substrate is arranged on both sides of the thin-film solar cell module 1, therewith protecting the solar cell module from environmental conditions, such as rain and hail.

FIG. 5 shows a greenhouse according to the second aspect of the invention comprising the thin film solar cell module according to the first aspect of the invention. At night time stray radiation of the light source 54 having a wavelength in the second wavelength domain is at least partially absorbed by the photo-electric layer 40 directly, or after reflection by the selectively reflecting layer 30. In this way not only stray radiation outside the greenhouse is reduced, but also part of the stray radiation is converted into useful electrical energy. The thin-film solar cell module is preferably arranged at the inner side of the wall(s) of the greenhouse, therewith protecting the

FIG. 6 shows the photo-electric layer 20 in more detail. A further photo-electric layer 40 as shown in FIG. 4 may have the same construction. The photo-electric layer 20 or 40 comprises a stack of sub-layers comprising a first electrode sub-layer 21, an active sub-layer 22 that comprises a mixture of an electron-donor material and an electron-acceptor material and a second electrode sub-layer 24. Alternatively the active sub-layer may be provided as combination of an electron-donor sub-sub-layer with donor material and an electron-acceptor sub-sub-layer with acceptor material arranged against each other. However, in the configuration as shown in FIG. 6, having a single active sub-layer 22 with a mixture of an electron-donor material and an electron-acceptor material a bulk hetero-junction is obtained providing a large interface between donor and acceptor. This is more efficient than a dual layer. The first and the second electrode sub-layer 21 and 24 should be transparent electrically conductive sub-layers, for example from a transparent conductive oxide (TCO), i.e. a metal oxide such as indium tin oxide (ITO), a conducting polymer. The electrode sub-layers 21, 24 may on their turn comprise two or more sub-sub-layers. To improve conductivity, the electrode sub-layers 21, 24 may be combined with a metal grid, as described in WO2011/016725, EP1693481 and W02010/0156763.

In a practical embodiment each of the photo-electric layer 20 and the further photo-electric layer 40 comprises an embedded electrically conductive grid, a layer of a conductive polymer, such as PEDOT:PSS, an active layer comprising the donor-acceptor blend, a cathode, possibly in the form of a stack of layers of mutually different transparent electrically conductive materials and a printed metallic grid. In an inverted arrangement the photo-electric layer 20 and the further photo-electric layer 40 may comprise a first electrically conductive grid, a layer of a conductive polymer, such as PEDOT:PSS, a zinc-oxide layer, a donor-acceptor blend, a further electrically conductive, transparent layer and a second electrically conductive grid.

Suitable electron-donor materials may be selected from the group consisting of polythiophenes, polyanilines, polyvinylcarbazoles, polyphenylenes, polyphenylvinylenes, polysilanes, polythienylenevinylenes, polyisothianaphthanenes, polycyclopentadithiophenes, polysilacylopentadithiophenes, polycyclopentadithiazoles, polythiazolothiazoles, polythiazoles, polybenzothiadiazoles, poly(thiophene oxide)s, poly(cyclopentadithiophene oxide)s, polythiadiazoloquinoxaline, polybenzoisothiazole, polybenzothiazole, polythienothiophene, poly(thienothiophene oxide), polydithienothiophene, poly(dithienothiophene oxide)s, polytetrahydroisoindoles, and copolymers thereof. For example, the electron donor material can include a polymer selected from the group consisting of polythiophenes (e.g., poly(3-hexylthiophene) (P3HT)), polycyclopentadithiophenes (e.g., poly(cyclopentadithiophene-cobenzothiadiazole)), and copolymers.

Suitable electron-acceptor materials may be selected from the group consisting of fullerenes, inorganic nanoparticles, oxadiazoles, discotic liquid crystals, carbon nanorods, inorganic nanorods, polymers containing CN groups, polymers containing CF3 groups, and combinations thereof. For example, the electron acceptor material can include a substituted fullerene (e.g., C61-phenyl-butyric acid methyl ester (PCBM)).

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of the "a" or "an" are employed to describe elements and components of the invention. This is done merely for convenience and to give a general sense of the invention. This description should be read to include one or at least one and the singular also includes the plural unless it is obvious that it is meant otherwise.

## Claims

1. A thin film solar cell module (1) that is substantially translucent in at least a first wavelength domain, the module comprising
- a photo-electric layer (20) arranged for receiving solar radiation and for converting solar radiation in at least a second wavelength domain different from the at least a first wavelength domain into electric energy,
- a selectively reflective layer (30) arranged against the photo-electric layer for selectively reflecting radiation in said second wavelength domain transmitted by the photo-electric layer.
- a further photo-electric layer (40) for absorbing and converting radiation in at least the second wavelength domain into electric energy, the selectively reflective layer (30) being arranged between the photo-electric layer (20) and the further photo-electric layer (40).

2. The thin film solar cell module according to claim 1, wherein the at least a first wavelength domain comprises a first wavelength band from 350 nm to 500 nm and a second wavelength band from 600 nm to 700 nm.

3. The thin film solar cell module according to claim 2, wherein the thin-film solar cell module transmits at least 50% of the radiation in said wavelength bands.

4. The thin film solar cell module according to claim 3, wherein the thin-film solar cell module transmits at least 75% of the radiation in said wavelength bands.

5. The thin film solar cell module according to claim 4, wherein the thin-film solar cell module transmits at least 90% of the radiation in said wavelength bands.

6. The thin film solar cell module according to claim 2, wherein the second wavelength domain comprises a wavelength range extending from 500 to 600 nm.

7. The thin film solar cell module according to claim 6, wherein the selectively reflective layer (30) has a reflectivity of at least 50% of the radiation in the second wavelength domain.

8. The thin film solar cell module according to claim 7, wherein the selectively reflective layer (30) has a reflectivity of at least 75% of the radiation in the second wavelength domain.

9. The thin film solar cell module according to claim 8, wherein the selectively reflective layer (30) has a reflectivity of at least 90% of the radiation in the second wavelength domain.

10. A photovoltaic greenhouse (50) comprising:
a main greenhouse frame structure comprising a wall (51) enclosing an inner space (52) for growing plants (53), at least one thin-film solar cell module (1) as claimed in one of the previous claims, mounted on said wall.
